# EUROPEAN PATENT SPECIFICATION

(11) **EP 2 884 368 B1**
(45) Date of publication and mention of the grant of the patent: **04.07.2018**
(21) Application number: 13306706.6
(22) Date of filing: 12.12.2013
(51) Int. Cl.: G06F 1/20, H01L 23/34, H01L 41/09

(54) **An apparatus for moving a fluid**
Vorrichtung zum Transport einer Flüssigkeit
Appareil destiné à déplacer un fluide

(43) Date of publication of application: 17.06.2015
(73) Proprietor: Alcatel Lucent, 91620 Nozay (FR)
(72) Inventor: Jeffers, Nicholas, Blanchardstown, DUBLIN (IE); Stafford, Jason, Blanchardstown, DUBLIN (IE); Donnelly, Brian, Blanchardstown, DUBLIN (IE)
(74) Representative: Shamsaei Far, Hassan

(56) References cited:
- WO-A1-98/54765
- US-A1- 2005 231 914
- H P J DE BOCK ET AL: "Experimental Flow Performance Evaluation of novel miniaturized Advanced Piezoelectric Dual Cooling Jet", JOURNAL OF PHYSICS: CONFERENCE SERIES, vol. 395, 012035, 26 November 2012 (2012-11-26), pages 1-11, XP055111485, ISSN: 1742-6588, DOI: 10.1088/1742-6596/395/1/012035

## Description

The present disclosure relates to cooling devices.

### BACKGROUND ART

A trend in producing electronic devices, in particular in the telecommunication field, is toward reducing their size while enabling such devices of processing increasingly larger volumes of data. Processing larger volumes of data typically involves higher levels of heat generation which in turn would require stronger and more efficient cooling mechanisms. In this regard passive heat transfer solutions (e.g. heat sinks) have often been replaced or complemented by active cooling techniques which are typically capable of removing larger quantities of heat from an electronic component. One example of such active cooling techniques is based on the use of rotary or radial fans. However there are drawbacks associated to the use of such fans as they are typically inherently unreliable with short life times (e.g. of about 7 years). Furthermore, the cost of ownership of equipment with such fans is typically high and they occupy a relatively large volume.

As an alternative to rotary or radial fans, other configurations based on actuating a cantilever have often been considered in the industry as a promising technology for active cooling as they are typically more reliable than rotary or radial fans. Briefly, cantilever fans typically use a planar body, such as a blade which is anchored at one end and is capable of oscillating in response to a driving force exerted thereon. For the sake of simplicity, herein these fan are herein also referred to as "oscillation blade fans". Some examples of such conventional oscillation blade fans are fans using materials with piezoelectric properties as driver element and fans using materials with electromagnetic properties as driver element. However, known oscillation blade fans are typically capable of generating airflows in the order of 10 liters/min with local velocities 1.5m/s which in certain applications may be insufficient. Document entitled "Experimental Flow Performance Evaluation of Novel Miniaturized Advanced Piezoelectric Dual Cooling Jet" by H P J De Bock and et al; Journal of Physics: Conference Series 395; 26 November 2012; page 012035 describes an evaluation of the flow performance of a piezoelectric dual cooling jet.

### SUMMARY

Some embodiments feature an apparatus comprising:
- a planar body;
- a driver connected to the planar body and configured to generate a motion in the planar body in response to an external excitation;
wherein the planar body comprises a flexible flat sheet with a first lateral side and a second lateral side, the first lateral side and the second lateral side diverging from each other in a direction moving away from the planar body; and
wherein the planar body further comprises a plurality of rigid structures wherein a first rigid structure is attached to the first lateral side of the flexible flat sheet and a second rigid structure is attached to the second lateral side of the flexible flat sheet such that the rigid structures provide support for the flexible flat sheet.

According to some specific embodiments, the flexible flat sheet is capable of elastically deflecting during an oscillation of the planar body said elastic deflection being opposite to a direction of oscillation of the planer body and generating a concave shape on the surface of the planar body which is in the direction of oscillation.

According to some specific embodiments, rigid structure is in the form of an elongated beam, and at least two elongated beams provide support for the flexible flat sheet.

The invention is defined by the appended claims. According to some specific embodiments, a rigid structure is in the form of a curved beam, and at least two curved beams provide support for the flexible flat sheet.

According to some specific embodiments, a lateral side comprises a multiple of segments and at least one segment on each lateral side is supported by a rigid structure.

According to some specific embodiments, the planar body has the shape of a fishtail.

According to some specific embodiments, the driver comprises a piezoelectric element.

According to some specific embodiments, the driver comprises an electromagnetic element.

Some embodiments feature an equipment comprising a plurality of electronic components, a plurality of heat sinks each configured to cool a respective one of the plurality of electronic components, the electronic components and the heat sinks being located on a board, the equipment further comprising a plurality of apparatus as featured herein, wherein a first apparatus is located proximate to a first heat sink and configured to locally cool the first heat sink and a second apparatus is located proximate to a second heat sink and configured to locally cool the second heat sink, and wherein the first heat sink and second heat sink are located at distant locations with respect to each other on the surface of the board.

These and further features and advantages of the present invention are described in more detail, for the purpose of illustration and not limitation, in the following description as well as in the claims with the aid of the accompanying drawings.

### BRIEF DESCRIPTION OF THE DRAWINGS

Figure 1 is an exemplary schematic representation of some structural aspect of a known oscillation blade fan.
Figure 2 is an exemplary schematic representation of some structural aspects of an oscillation blade fan according to some embodiments.
Figures 3A, 3B and 3C, are exemplary schematic representations of some structural aspects of an oscillation blade fan according to embodiments of the present disclosure.
Figures 4A and 4B are exemplary schematic representation of some structural aspect of an oscillation blade fan according to some embodiments.
Figure 5A is an exemplary schematic representation in perspective of an oscillation blade fan according to some embodiments and figure 5B is a front view of the fan of figure 5A.
Figure 6 is an exemplary schematic representation of a circuit for an equipment using electronic circuits and oscillation blade fans according to some embodiments.

### DETAILED DESCRIPTION

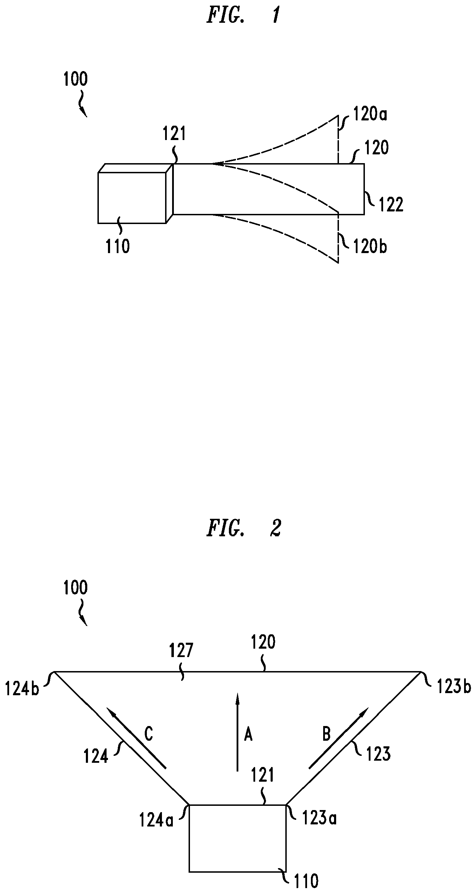

Before describing the various embodiments of the disclosure, a brief description of an exemplary known oscillation blade fan, in this example being a piezoelectric fan, is provided with reference to figure 1. It is to be noted that the present description of a known piezoelectric fan is provided only to help facilitating a better understanding of the present disclosure and is not to be construed as being limited to only the described aspects.

Typically a piezoelectric fan 100 is made of a piezoelectric element 110 comprising a body of a solid material having the property of accumulating electrical charge when a mechanical stress such as a pressure is applied thereupon. Conversely, such piezoelectric body may exhibit a mechanical movement in response to an electric current applied thereto. Some examples of materials exhibiting piezoelectric property are certain crystals or ceramics. A piezoelectric fan further comprises a planar, typically thin, body 120 (sometimes referred to as blade or cantilever). One end 121 of the planar body 120 is attached, e.g. bonded, to the piezoelectric element 110 and the other end 122 of the body is free and movable. When an alternating electric current is applied to the piezoelectric element 110, the latter exhibits a mechanical movement, causing the opposite free end 122 of the planar body 120 to move in an oscillating pattern which is represented in the figure by dashed lines 120-a and 120-b. The oscillation of the free end 122 of the planar body generates an airflow in a similar manner as a conventional hand fan.

The piezoelectric element 110 is typically coupled to a coupling which includes electrical connections used for conveying an alternating current to the piezoelectric element.

Although piezoelectric fans have advantages over the conventional rotary or radial fans, for example due their better reliability, they still suffer from certain shortcomings. One such shortcoming is that a conventional piezoelectric fan is typically only capable of generating airflows in the order of 10 liters/min with local velocities of about 1.5m/s. These performance parameters may not be sufficient for applications where relatively compact circuit packs are to be cooled, especially where such compact circuit packs are designed to process large volumes of data.

Similar considerations may be given to known oscillation blade fans using electromagnetic drivers in terms of possible insufficiency of their performance parameters for certain applications.

Figure 2 illustrates an exemplary schematic representation of some structural aspects of an oscillation blade fan according to some embodiments. In this non-limiting example, the fan uses a piezoelectric material as a driver for the fan blade as will be described below, however other drives, such as for example electromagnetic drivers may likewise be used and are to be considered within the scope of the present disclosure. In figure 2, like elements have been provided with like reference numerals as those of figure 1.

The piezoelectric fan 100 of figure 2 comprises a driver 110 of piezoelectric material and a planar body 120. The planar body comprises a flat and thin sheet 127. One end 121 of the planar body 120 is attached, e.g. bonded, to the driver 110 and the other end 122 of the body is free and movable. When an external excitation, such as an alternating electric current is applied to the piezoelectric element of driver 110, the latter exhibits a mechanical movement, causing the opposite free end 122 of the planar body 120 to move in an oscillating pattern. The oscillation of the free end 122 of the planar body generates an airflow. The flat sheet 127 of the planar body has at least two lateral sides 123 and 124 where each of the two lateral sides has a respective first end 123-a, 124-a, connected to the driver 110 and a respective second end 123-b,124-b, opposite to the respective first end, which is free and moveable.

According to embodiments of the present disclosure the two lateral sides 123 and 124 diverge from each other in a direction moving away from the driver 110. As shown in the figure, such direction of movement is from the respective first ends 123-a, 124-a to the respective second ends 123-b, 124-b respectively. The direction from the respective first ends to the respective second ends is shown in figure 2 by arrow A and the divergence effect is represented in the figure by divergent arrows B and C.

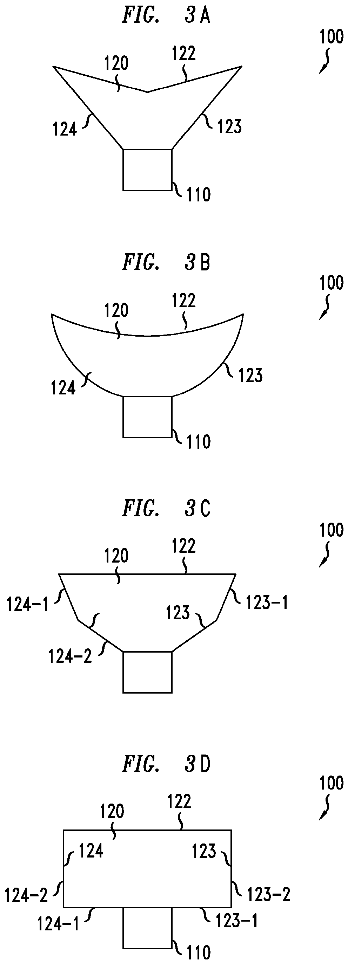

In the example of figure 2, the planar body is shown to have a generally triangular shape. However, this is only exemplary and other suitable geometries may also be used for the planar body 120. Figures 3A, 3B, 3C and 3D, illustrate examples implementing some of such alternative geometries for the planar body. In particular, the lateral sides 123, 124 and the free end 122 may have linear shapes such as the embodiment of figure 3A, curved shapes such as the embodiment of figure 3B or a combination of curved and linear shapes.

Furthermore, each of the two lateral sides may have multiple linear segments. For example, the planar body 120 of figure 3C is shown to have lateral sides 123 and 124 where the lateral side 123 may comprise a first linear segment 123-1 and a second linear segment 123-2 and the lateral side 124 may comprise a first linear segment 124-1 and a second linear segment 124-2. Similarly (although not shown in the figures) each of the two lateral sides may have multiple curved shapes. For example, each of the lateral sides of the planar body may comprise a first curved portion and a second curved portion. Still further, the lateral sides having multiple linear segments may diverge from the first end substantially at 180 degrees. For example, the planar body 120 of figure 3D is shown to have lateral sides 123, 124 with linear segments123-1, 123-2 and 124-1 and 124-2 respectively, wherein the linear segments 123-1 and 123-2 diverge from the first end 121 at an angle which is substantially at 180 degrees.

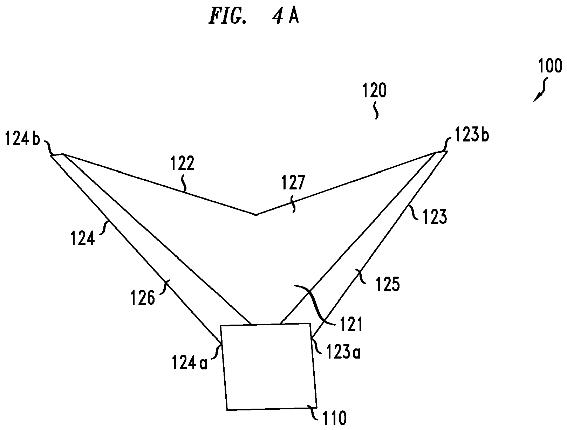

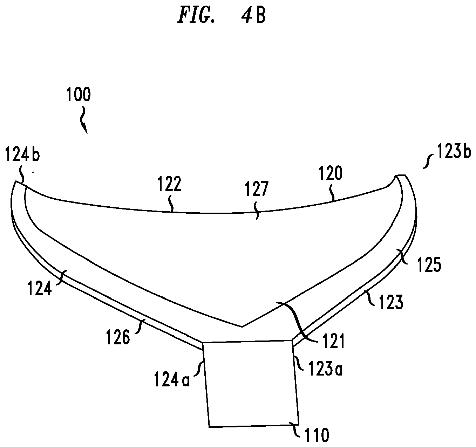

The planar body further comprises rigid structures on the lateral sides of the planar body. Figures 4A and 4B illustrate examples of embodiments in which the planar body of the fan 100 comprises such rigid structures. In figures 4A and 4B like elements have been provided with like reference numerals as those of the previous figures. The fan 100 of figure 4A is in many aspects similar to that of figure2. However, the fan of figure 4A further includes rigid structures 125 and 126 located on the lateral sides 123 and 124 of the planar body respectively. The rigid structures may be used as a supporting frame for the flat sheet 127 which is also a part of the planar body 120.

In some embodiments, such as the one shown in figure 4A, individual rigid structures 125 and 126 may be in the form of an elongated linear beam, and at least two elongated beams provide support for the flexible flat sheet.

One advantage of using rigid structures on the lateral sides of the planar body is that they may contribute to improving the frequency of oscillation of the planar body as compared to piezoelectric fans which do not have rigid structures on the lateral sides of their planar body. For example, it is expected that using the rigid structures may enable reaching frequencies in the range of about 88Hz which is a significant improvement as compared to the conventional piezoelectric fans which, for the same oscillation amplitude, typically operate at frequencies of about 60Hz.

Figure 4B illustrates an alternative shape of the planar body 120 where the planar body also comprises rigid structures 125 and 126 on lateral sides of the planar body which support the flat sheet 127. The characteristics of the fan of figure 4B is in many aspects similar to that of figure 4A and therefore a detailed description thereof is considered not necessary. The main difference between the embodiments of figures 4A and 4B is in the geometrical shape of the respective planar bodies which in the former it is composed of linear lateral sides 123, 124 as well as linear geometry of the free end 122 and in the latter it is composed of curved lateral sides 123, 124 as well as curved geometry of the free end. Similar to the embodiment of figure 4A, the rigid structures 126, 126 may be in the form of an elongated curved beam and at least two elongated curved beams provide support for the flexible flat sheet.

Preferably the shape of the planar body may resemble the shape of a fishtail. For example the planar bodies of the embodiments of figures 3A, 3B, 3C, 4A and 4B illustrate fishtail shapes. This may be based on a biomimetic approach for designing the planar bodies which may be very advantageous as it takes advantage of natural shapes of fishtails that have been evolving over millions of years to optimize their efficiency in facilitating the movements of the fish in water. The movement of a fish using its fishtail in water (a fluid) may therefore be resembled to the movement of a planar body of a piezoelectric fan in air (a fluid). In the context of the present disclosure biomimetic may be understood to refer to an approach that mimics the shape and function of a structure that has been biologically produced in the nature. It is therefore considered that designs based on fishtail geometries would improve the performance of the planar body in moving air or other fluids including water.

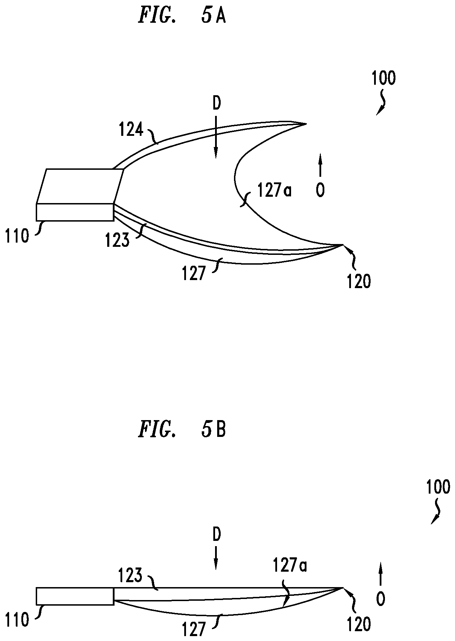

In some embodiments the flat sheet 127 of the planar body 120 is made of a flexible material. This is advantageous because the flexibility of the flat sheet makes it capable of undergoing an elastic deflection. By elastic deflection it is meant to refer to the capability of the flexible flat sheet 127 to deform during the oscillation of the planar body. Figures 5A and 5B illustrate this feature.

Figure 5A is an exemplary schematic representation in perspective of a fan having a flexible flat sheet included in the planar body thereof, and figure 5B is a front view of the piezoelectric fan of figure 5A.

In these figures like elements have been given like reference numerals as those of the previous figures. It is assumed that in both figures 5A and 5B, the fan 100 is in operation in which the planar body 120 is undergoing an oscillating movement in the direction of arrow O (it is further noted that the entire oscillation of the tip of the planar body may define a curved pattern, however arrow O is intended to show the instantaneous vector at the instant of oscillation shown in the figure, therefore the arrow is shown to be linear). Due to the movement of the planar body in the direction of arrow O and the fact that the flat sheet 127, spanning between the two rigid structures 123 and 124 is flexible, the flat sheet 127 undergoes a deformation which deepens as one moves from the sides of the flat sheet to the center thereof, therefore forming a concave shape on the surface 127-a of the planar body, which is the upper surface of the flat sheet 127 being in the direction of oscillation O as shown in figures 5A and 5B. This deformation constitutes, within the context of the present disclosure, an elastic deflection of the flat sheet 127.

As it may be readily observed from the figures 5A and 5B, when the planar body is moving in the direction of arrow O (upward in the figures), the elastic deflection is generated in the opposite direction (downward in the figures). The direction in which the elastic deflection is generated is shown in the figures by arrows D.

Such elastic deformation offers a significant advantage as compared to conventional oscillation blade fans in which the planar bodies do not typically undergo such elastic deflection, because it allows the planar body to capture comparatively higher volumes of air within the elastically deformed region as shown under the arrow D in figures 5A and 5B, thereby moving a larger volume of air toward the electronic components to be cooled.

The material of flexible flat sheet may be of any known type available on the market. One example of such material may be latex.

For the sake of clarity of description it is noted that the term rigid, as referred to the structures supporting the flat sheet is to be understood as a structure having less flexibility as compared to the flat and flexible sheet used in the planar body. Although rigidity and flexibility are both relative properties, it is noted that within the context of the present disclosure, a person of ordinary skill in the art will be able to select the desired level of rigidity for the rigid structures in view of the level of flexibility selected for the flexible flat sheet for each specific design such that an optimum fluid movement is obtained.

It is expected that oscillation blade fans constructed according to the embodiments of the disclosure may present improved performance in air moving efficiency from typical peak velocities in the range of 1.5m/s for conventional piezoelectric fans to peak velocities in the range of 5m/s.

Although the above exemplary embodiments have been described in relation to a cooling mechanism which uses air as the cooling fluid, the disclosure is not so limited and other fluids, such as for example water, may also be used as cooling fluids within the context of the present disclosure.

As mentioned above, the disclosure is not limited to the use of piezoelectric drivers and oscillation blade fans (or cantilever fans) using other known driver mechanisms, such as electromagnetic drivers may likewise be employed within the context of the present disclosure.

By way of a non-limiting example, electromagnetic drivers may use electromagnetic force which is applied to the blade, the latter being anchored at one end to a fixed point and free at another. The electromagnetic driver (which may be an electromagnetic coil) may be located at a convenient position away from the body of the blade. By applying an external excitation, such as an alternating current, or by turning the current on and off periodically, a magnetic force is periodically induced in the coil which as a result periodically attracts the blade towards the coil, thereby generating an oscillation movement in the blade. Another non-limiting example of electromagnetic drivers may use an induction device to move a magnet which may be anchored to a blade and thereby cause movement therein.

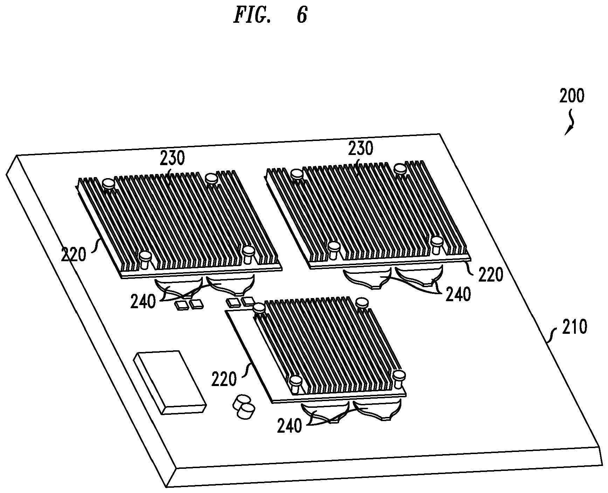

Some embodiments feature an equipment in which the piezoelectric fan according the various embodiments of the disclosure may be implemented. Figure 6 is an exemplary schematic representation of a circuit for such an equipment according to some embodiments.

The circuit 200 of figure 6 comprises a circuit board 210 on which a plurality of electronic components 220 are provided. The electronic components are of the type that generates heat during their operation. A plurality of heat sinks 230 is provided configured to passively cool the electronic circuits. As shown in the figure, individual electronic components 220 and individual heat sinks are provided in thermal contact with each other and pairs of electronic component-heat sink are located at various locations on the surface of the board 210 which may be at certain distance with respect to each other.

According to embodiments of the disclosure, a plurality of oscillation blade fans 240 are located on the board 210 in such a manner that one or more piezoelectric fans 240 may be located proximate to a respective heat sink and be used to locally cool the respective heat sink (and the electronic component). In figure 6, thee electronic components 220 are shown in thermal contact with three heat sinks 230 and for each pair of component-heat sink, two fans 240 are located proximate thereto. The number of fans used in the figure is only exemplary and of course any suitable number of piezoelectric fans may be used proximate to a component-heat sink pair to meet the requirements of each specific design.

This arrangement has important advantages over the arrangements used in known equipment. Indeed the arrangements used in known equipment are typically cooled by forced convection via a bank of fans. The fans may be axial or radial and due to the size of such fans, they are typically located on a side, e.g. the bottom of the board in a vertically positioned board. The airflow therefore moves from the bottom to the top of the board. This configuration often causes difficulty in cooling various components on the circuit packs as the air moving from the bottom to the top becomes progressively heated as it flows over the electronic components and the heat sinks. Therefore the components located further away from the fans (downstream the flow of air) will receive warmer air as compared to those located closer to the fans (upstream the flow o fair).

The oscillation blade fans according to the present disclosure may help improve the situation because, on the one hand, due to their reduced size they may be located within the board (as opposed to a side of the board) and proximate to each electronic component - heat sink pair to thereby locally cool such components; and on the other, they may produce larger volumes of airflow due to the specific shape of these fans having a comparatively larger surface for the planar body as compared to known piezofans. The use of a flexible material supported between rigid structures for the planar body enhances still more the performance of the fan, as described above.

The use of the fans as featured herein within the surface of the board would not significantly affect the availability of space on the board as the footprint that the fan occupies is very small, and furthermore, various components could easily be positioned below the fan at locations which do not obstruct the oscillating movement of the tip of the fan.

Optionally, the fan as proposed herein may be used for generating a local airflow in addition to the use of a remote airflow which may be provided using rotary or axial fans on a side of the board, wherein the local and remote airflows are in the same direction. This option may therefore help increase further the airflow over the entire board. Such a combined airflow would be difficult to achieve with other air moving technologies such as axial/radial fans especially in small and compact devices. Here again, the specific shape of the fan as proposed herein would generate a local increase in airflow which may be significantly greater than what could be generated by a known piezoelectric fan.

The various embodiments of the present invention may be combined as long as such combination is compatible and/or complimentary.

Further it is to be noted that the list of structures corresponding to the claimed elements is not exhaustive and that one skilled in the art understands that equivalent structures can be substituted for the recited structure without departing from the scope of the invention.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

## Claims

1. An apparatus (100) for cooling an electronic device comprising:
- a planar body (120);
- a driver (110) connected to the planar body (120) and configured to generate a motion in the planar body in response to an external excitation;
wherein the planar body (120) comprises a flexible flat sheet (127) with a first lateral side (123) and a second lateral side (124); the apparatus being **characterized in that** the first lateral side (123) and the second lateral side (124) diverge from each other in a direction moving away from the driver; wherein the planar body (120) further comprises a plurality of rigid structures (125, 126) wherein a first rigid structure (125) is attached to the first lateral side (123) of the flexible flat sheet and a second rigid structure (126) is attached to the second lateral side (124) of the flexible flat sheet such that the rigid structures provide support for the flexible flat sheet; and wherein the rigid structures (125, 126) are configured to move together with the planar body (120) in response to the motion generated by the driver (110).

2. The apparatus of claim 1, wherein the flexible flat sheet is capable of elastically deflecting during an oscillation of the planar body said elastic deflection being opposite to a direction of oscillation of the planer body and generating a concave shape on the surface of the planar body which is in the direction of oscillation.

3. The apparatus of any one of the preceding claims, wherein the rigid structure is in the form of an elongated beam, and at least two elongated beams provide support for the flexible flat sheet.

4. The apparatus of any one of the preceding claims, wherein the rigid structure is in the form of a curved beam, and at least two curved beams provide support for the flexible flat sheet.

5. The apparatus of any one of the preceding claims wherein the first and the second lateral side comprises a multiple of segments and at least one segment on each lateral side is supported by the rigid structures.

6. The apparatus of any one of the previous claims, wherein the planar body has the shape of a fishtail.

7. The apparatus of any one of the preceding claims, wherein the driver comprises a piezoelectric element.

8. The apparatus of any one of the preceding claims 1 to 7, wherein the driver comprises an electromagnetic element.

9. An equipment comprising a plurality of electronic components, a plurality of heat sinks (230) each configured to cool a respective one of the plurality of electronic components (220), the electronic components (220) and the heat sinks (230) being located on a board (210), the equipment further comprising a plurality of apparatus (100, 240) as claimed in any one of the claims 1 to 8, wherein a first apparatus (240) is located proximate to a first heat sink (230) and configured to locally cool the first heat sink and a second apparatus (240) is located proximate to a second heat sink (230) and configured to locally cool the second heat sink, and wherein the first heat sink and second heat sink are located at distant locations with respect to each other on the surface of the board (210).

## Patentansprüche

1. Vorrichtung (100) zum Kühlen eines elektronischen Geräts, umfassend:
- einen ebenen Körper (120);
- einen Treiber (110), der mit dem ebenen Körper (120) verbunden und konfiguriert ist zum Erzeugen einer Bewegung in dem ebenen Körper als Antwort auf eine externe Anregung;
wobei der ebene Körper (120) umfasst ein flexibles Flachblech (127) mit einer ersten Lateralseite (123) und einer zweiten Lateralseite (124); wobei die Vorrichtung **dadurch gekennzeichnet ist, dass** die erste Lateralseite (123) und die zweite Lateralseite (124) von einander divergieren in eine Richtung, die sich vom Treiber weg bewegt; wobei der ebene Körper (120) weiterhin umfasst eine Vielzahl rigider Strukturen (125, 126), wobei eine erste rigide Struktur (125) angebracht ist an die erste Lateralseite (123) des flexiblen Flachblechs und eine zweite rigide Struktur (126) angebracht ist an die zweite Lateralseite (124) des flexiblen Flachblechs, sodass die rigiden Strukturen Unterstützung bieten für das flexible Flachblech; und wobei die rigiden Strukturen (125, 126) konfiguriert sind zum Bewegen mit dem ebenen Körper (120) als Antwort auf die vom Treiber (110) erzeugte Bewegung.

2. Vorrichtung nach Anspruch 1, wobei das flexible Flachblech in der Lage ist, während einer Oszillation des ebenen Körpers elastisch zu verformen, wobei besagte elastische Verformung einer Oszillationsrichtung des ebenen Körpers entgegengesetzt ist und eine konkave Form auf der Oberfläche des ebenen Körpers erzeugt, die in Richtung der Oszillation liegt.

3. Vorrichtung nach einem beliebigen der vorhergehenden Ansprüche, wobei die rigide Struktur die Form eines länglichen Stabes hat, und wobei mindestens zwei längliche Stäbe Unterstützung bieten für das flexible Flachblech.

4. Vorrichtung nach einem beliebigen der vorhergehenden Ansprüche, wobei die rigide Struktur die Form eines gebogenen Stabs annimmt und mindestens zwei gebogene Stäbe Unterstützung bieten für das flexible Flachblech.

5. Vorrichtung nach einem beliebigen der vorhergehenden Ansprüche, wobei die erste und die zweite Lateralseite mehrere Segmente umfassen und mindestens ein Segment jeder Lateralseite gestützt wird durch die rigiden Strukturen.

6. Vorrichtung nach einem beliebigen der vorhergehenden Ansprüche, wobei der ebene Körper die Form eines Fischschwanzes hat.

7. Vorrichtung nach einem beliebigen der vorhergehenden Ansprüche, wobei der Treiber ein piezoelektrisches Element umfasst.

8. Vorrichtung nach einem beliebigen der vorhergehenden Ansprüche 1 bis 7, wobei der Treiber ein elektromagnetisches Element umfasst.

9. Gerät umfassend eine Vielzahl von elektronischen Komponenten, eine Vielzahl von Kühlkörpern (230), jede konfiguriert zum Kühlen einer entsprechenden der Vielzahl elektronischer Komponenten (220), wobei die elektronischen Komponenten (220) und die Kühlkörper (230) auf einer Platte (210) lokalisiert sind, wobei das Gerät weiterhin umfasst eine Vielzahl von Vorrichtungen (100, 240) nach einem beliebigen der Ansprüche 1 bis 8, wobei eine erste Vorrichtung (240) in der Nähe des ersten Kühlkörpers (230) lokalisiert ist und konfiguriert ist zum lokalen Kühlen des ersten Kühlkörpers und eine zweite Vorrichtung (240) in der Nähe eines zweiten Kühlkörpers (230) lokalisiert ist und konfiguriert ist zum lokalen Kühlen des zweiten Kühlkörpers, und wobei der erste Kühlkörper und der zweite Kühlkörper jeweils an verschiedenen Orten auf der Plattenoberfläche (210) lokalisiert sind.

## Revendications

1. Appareil (100) destiné à refroidir un dispositif électronique comprenant :
- un corps planaire (120) ;
- un dispositif d'entraînement (110) couplé au corps planaire (120) et configuré pour générer un déplacement dans le corps planaire en réponse à une excitation externe ;
dans lequel le corps planaire (120) comprend une feuille plate flexible (127) avec un premier côté latéral (123) et un second côté latéral (124) ; l'appareil étant **caractérisé en ce que** le premier côté latéral (123) et le second côté latéral (124) divergent l'un de l'autre dans une direction s'éloignant du dispositif d'entraînement ;
dans lequel le corps planaire (120) comprend en outre une pluralité de structures rigides (125, 126) dans laquelle une première structure rigide (125) est fixée au premier côté latéral (123) de la feuille plate flexible et une seconde structure rigide (126) est fixée au second côté latéral (124) de la feuille plate flexible de telle sorte que les structures rigides fournissent un support pour la feuille plate flexible ; et dans laquelle les structures rigides (125, 126) sont configurées pour se déplacer avec le corps planaire (120) en réponse au déplacement généré par le dispositif d'entraînement (110).

2. Appareil selon la revendication 1, dans lequel la feuille plate flexible est capable de déflexion élastique pendant une oscillation du corps planaire, ladite déflexion élastique étant opposée à une direction d'oscillation du corps plan et générant une forme concave sur la surface du corps planaire qui est dans la direction d'oscillation.

3. Appareil selon l'une quelconque des revendications précédentes, dans lequel la structure rigide est sous la forme d'un membre allongé, et au moins deux membres allongés fournissent un support pour la feuille plate flexible.

4. Appareil selon l'une quelconque des revendications précédentes, dans lequel la structure rigide est sous la forme d'un membre courbe, et au moins deux membres courbes fournissent un support pour la feuille plate flexible.

5. Appareil selon l'une quelconque des revendications précédentes dans lequel le premier et le second côté latéral comprennent plusieurs segments et au moins un segment sur chaque côté latéral est supporté par les structures rigides.

6. Appareil selon l'une quelconque des revendications précédentes, dans lequel le corps planaire a la forme d'une queue de poisson.

7. Appareil selon l'une quelconque des revendications précédentes, dans lequel le dispositif d'entraînement comprend un élément piézoélectrique.

8. Appareil selon l'une quelconque des revendications précédentes 1 à 7, dans lequel le dispositif d'entraînement comprend un élément électromagnétique.

9. Équipement comprenant une pluralité de composants électroniques, une pluralité de dissipateurs de chaleur (230) chacun configuré pour refroidir un composant respectif de la pluralité de composants électroniques (220), les composants électroniques (220) et les dissipateurs de chaleur (230) étant localisés sur une carte (210), l'équipement comprenant en outre une pluralité d'appareils (100, 240) selon l'une quelconque des revendications 1 à 8, dans lequel un premier appareil (240) est localisé à proximité d'un premier dissipateur de chaleur (230) et configuré pour refroidir localement le premier dissipateur de chaleur et un second appareil (240) est localisé à proximité d'un second dissipateur de chaleur (230) et configuré pour refroidir localement le second dissipateur de chaleur, et dans lequel le premier dissipateur de chaleur et le second dissipateur de chaleur sont localisés à des emplacements distants l'un par rapport à l'autre sur la surface de la carte (210).
